# FASCICULE DE BREVET EUROPEEN

(11) **EP 2 132 777 B1**
(45) Date de publication et mention de la délivrance du brevet: **16.01.2013**
(21) Numéro de dépôt: 08788098.5
(22) Date de dépôt: 01.04.2008
(51) Int. Cl.: H01L 27/16, H02J 7/00, H04M 1/02, H01L 35/30

(54) **CONVERTISSEUR ELECTRIQUE MONOLITHIQUE ISOLE**
ISOLIERTER MONOLITHISCHER ELEKTRISCHER UMRICHTER
ISOLATED MONOLITHIC ELECTRICAL CONVERTER

(30) Priorité: 02.04.2007 FR 0754200
(43) Date de publication de la demande: 16.12.2009
(73) Titulaire: STMicroelectronics SA, 92120 Montrouge (FR)
(72) Inventeur: MORAND, Jean-Luc, F-37100 Tours (FR)
(74) Mandataire: de Beaumont, Michel
(86) Numéro de dépôt international: PCT/FR2008/050572
(87) Numéro de publication internationale: WO 2008/142317

(56) Documents cités:
- EP-A- 0 186 601
- WO-A-94/16464
- FR-A- 2 758 220
- JP-A- 2002 291 166
- US-A- 4 571 608
- US-A- 6 013 935

## Description

### Domaine de l'invention

La présente invention concerne un convertisseur électrique susceptible de fournir à son secondaire une alimentation électrique continue basse tension isolée d'une alimentation de puissance appliquée à son primaire. L'invention vise notamment le cas où l'alimentation appliquée au primaire est la tension alternative du secteur à 50 ou 60 Hz. On dira alors que le convertisseur est une alimentation secteur.

La présente invention vise notamment l'utilisation d'un tel convertisseur comme chargeur d'un téléphone portable. De tels convertisseurs trouveront de nombreuses autres applications, par exemple pour l'alimentation d'un programmateur d'appareil électroménager.

### Exposé de l'art antérieur

L'une des contraintes imposées à une alimentation secteur est que le secondaire doit être isolé galvaniquement du primaire. Une alimentation secteur comporte généralement un transformateur qui en constitue l'élément le plus lourd et le plus encombrant. Ce transformateur est lié à un circuit électronique de redressement du courant alternatif, comprenant par exemple un pont de diodes, divers éléments résistifs et capacitifs, une diode de type Zener pour établir une référence de tension continue ainsi qu'éventuellement des transistors, thyristors et/ou triacs pour la stabilisation du courant ou de la tension.

Ainsi, de façon générale, les convertisseurs existants ne sont pas monolithiques.

De plus, en raison de leur poids et de leur encombrement, les convertisseurs classiques ne peuvent être incorporés à un appareil portable tel qu'un téléphone portable. Le document US6013935 divulgue un interrupteur à état solid. La résistance et les éléments thermoélectriques sont déposés sous forme de couches sur un substrat.

Un appareil portable est généralement muni d'une batterie rechargeable que l'utilisateur n'utilise qu'en mode nomade et est commercialisé avec un chargeur lié à un fil pour être connecté d'une part à une prise d'alimentation de l'appareil portable, d'autre part au secteur. L'utilisateur d'un téléphone portable doit donc emporter dans ses déplacements un chargeur qui est souvent aussi volumineux que son téléphone et éventuellement plus lourd.

A ce jour, il n'existe pas d'alimentation secteur ou chargeur de faible encombrement qui puisse être facilement disposé dans un téléphone portable ou autre petit appareil portable tel qu'un ordinateur de poche qui permette ainsi de brancher l'appareil à une prise électrique du secteur à l'aide d'un simple câble d'alimentation.

### Résumé de l'invention

Ainsi, un mode de réalisation de la présente invention prévoit un convertisseur électrique monolithique isolé comprenant, sur un substrat en un matériau résistif dont la face inférieure comporte deux électrodes d'entrée distantes l'une de l'autre constituant un primaire, une couche isolante, et au moins deux éléments de matériaux thermoélectriques semiconducteurs dopés respectivement P et N connectés électriquement en série, les extrémités de la connexion série constituant le secondaire du convertisseur.

Selon un mode de réalisation de la présente invention, chaque élément thermoélectrique comprend une métallisation sur sa face supérieure et une métallisation sur sa face inférieure.

Selon un mode de réalisation de la présente invention, le substrat est en silicium.

Selon un mode de réalisation de la présente invention, le premier élément de matériau thermoélectrique semiconducteur dopé P est constitué de tellure de bismuth dopé à l'antimoine et le second élément de matériau thermoélectrique semiconducteur dopé N est constitué de tellure de bismuth dopé au sélénium.

Selon un mode de réalisation de la présente invention, le convertisseur comporte une pluralité de cellules thermoélectriques connectées en série les unes aux autres.

### Brève description des dessins

Des modes de réalisation particuliers de la présente invention seront exposés en détail dans la description suivante faite à titre non-limitatif en relation avec les figures jointes parmi lesquelles :
la figure 1 est une vue schématique d'un exemple de convertisseur monolithique isolé utilisant des éléments thermoélectriques selon un mode de réalisation de la présente invention ;
la figure 2 est une vue détaillée en coupe d'un exemple d'un convertisseur monolithique isolé selon un mode de réalisation de la présente invention ;
la figure 3 est une vue en coupe du convertisseur de la figure 2 montée sur un support muni d'un refroidisseur ; et
la figure 4 représente différentes étapes d'un procédé de réalisation du convertisseur de la figure 2.

### Description détaillée

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

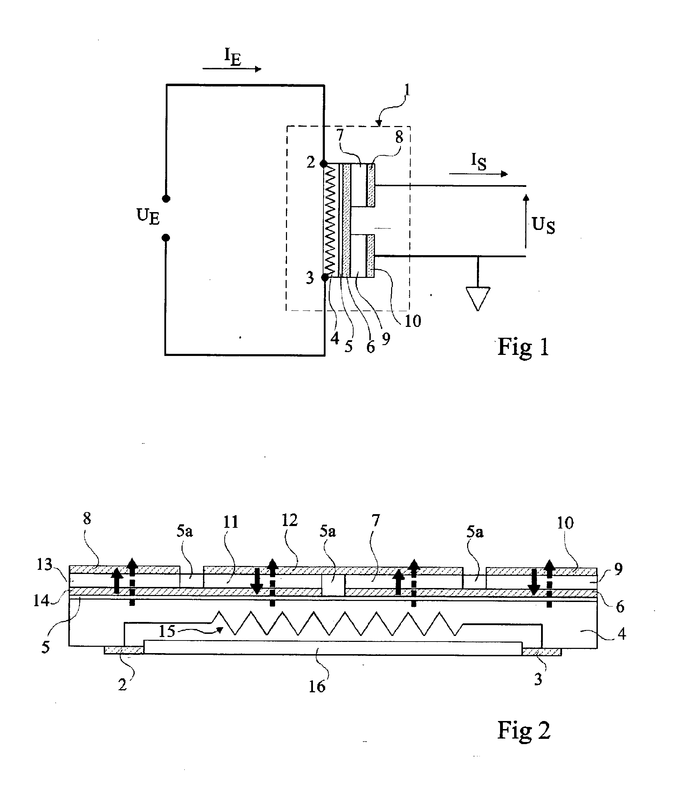

La figure 1 illustre un exemple de convertisseur monolithique isolé 1 alimenté à son primaire par une source alternative de tension Ue et de courant Ie, et fournissant à son secondaire une tension continue Us et un courant Is. La tension Ue est appliquée entre deux bornes 2 et 3 de la face arrière d'une plaquette de silicium 4. La face avant de la plaquette de silicium 4 est recouverte d'une couche électriquement isolante, mais bonne conductrice thermique, 5. Sur la couche 5, une électrode 6 relie électriquement les faces inférieures de deux éléments thermoélectriques constitués de couches de semiconducteurs N et P (ou vice versa) 7 et 9, munies d'électrodes 8 et 10 sur leurs faces supérieures. Les électrodes 8 et 10 constituent les bornes de sortie ou secondaire de l'alimentation.

En fonctionnement, la plaquette de silicium traversée par un courant voit sa température s'élever par effet Joule. Cette augmentation de température se transmet par l'intermédiaire de la couche électriquement isolante 5 à l'électrode 6 et aux faces inférieures des éléments thermoélectriques 7 et 9. La température des électrodes 8 et 10 du côté des faces opposées des éléments thermoélectriques 7 et 9 reste voisine de la température ambiante. Il se crée donc, par effet Seebeck, une différence de potentiel continue Us entre les électrodes 8 et 10 des éléments thermoélectriques 7 et 9 connectés en série et soumis à un gradient de température. Les électrodes 8 et 10 sont donc susceptibles de fournir un courant continu Is à une charge non représentée sur la figure. Cette charge sera par exemple une batterie. Divers éléments de régulation de courant et/ou de tension peuvent être insérés entre la source de tension continue Us et la charge.

La figure 2 est une vue en coupe schématique agrandie d'un autre exemple de convertisseur monolithique isolé 1. Les mêmes éléments que ceux de la figure 1 portent les mêmes références. A la différence de la figure 1 sur laquelle une seule paire d'éléments thermoélectriques est représentée (un élément N et un élément P connectés en série), la figure 2 représente deux paires d'éléments thermoélectriques 7-9 et 11-13, alternativement des éléments N (9 et 11) et des éléments P (7 et 13). Ces éléments sont reliés électriquement en série. Une électrode 6 relie les faces arrière des éléments 7 et 9, une électrode 12 relie la face avant de l'élément 7 à la face avant de l'élément 11, et une électrode 14 relie les faces arrière des éléments 11 et 13. La tension de sortie continue est disponible (en fonctionnement) entre une électrode 10 sur la face avant de l'élément 9 et une électrode 8 sur la face avant de l'élément 13. Les éléments 7, 9, 11 et 13 sont isolés latéralement par une couche électriquement isolante 5a qui fait que la surface supérieure du dispositif est sensiblement plane, ce qui facilite notamment le dépôt de couches conductrices sur cette face supérieure. La couche isolante 5 qui sépare les électrodes 6 et 14 du substrat en silicium 4 est de préférence en un matériau à la fois isolant électrique et conducteur thermique de manière à assurer un bon couplage thermique entre le substrat 4 et les éléments thermoélectriques 7, 9, 11 et 13. Même si le matériau de la couche isolante 5 n'est pas un très bon conducteur thermique, cette couche sera choisie suffisamment mince pour ne pas affecter sensiblement la conduction thermique entre le substrat et les faces arrière des éléments thermoélectriques.

Sur la figure 2, les flèches illustrent respectivement le flux thermique (flèches en pointillés) et le sens de la tension se développant aux bornes de chaque élément thermoélectrique quand il est soumis à un gradient de température (flèches en trait continu).

Le substrat en silicium 4 est muni du côté de sa face inférieure de deux électrodes 2 et 3 d'entrée du courant primaire. Les parties de la face inférieure non revêtues des électrodes 2 et 3 sont de préférence recouvertes d'une couche électriquement isolante 16 qui pénètre éventuellement dans le substrat. On a représenté symboliquement une résistance 15 entre les deux électrodes 2 et 3 schématisant ainsi l'écoulement résistif du courant alternatif qui provoque l'échauffement dudit substrat 4 qui se comporte ainsi en source chaude pour les éléments thermoélectriques (dont les faces opposées sont à température ambiante).

Ci-après sont donnés deux exemples de réalisation d'un convertisseur monolithique isolé 1 tel que représenté sur la figure 2.

### Exemple 1

Dans un premier exemple de réalisation, le primaire de l'alimentation reçoit la tension alternative Ue du secteur d'une valeur efficace de 230 volts à une fréquence de 50 hertz. La distance entre les électrodes 2 et 3, l'épaisseur du substrat de silicium 4, éventuellement ajustée par la pénétration de la couche électriquement isolante 16, et le dopage du silicium sont choisis pour que la résistance 15 ait une valeur Rp de 17,6 kΩ. Le silicium est donc traversé par un courant Ip de 13 mA ce qui correspond à une puissance totale dissipée au primaire de 3 watts.

On utilise quatre éléments thermoélectriques, respectivement 9 et 11 dopés N (par exemple en tellure de bismuth dopé au sélénium) et 7 et 13 dopés P (par exemple en tellure de bismuth dopé à l'antimoine). Ces éléments ont de façon classique un rendement de conversion Seebeck de 6 % (le rendement de conversion Seebeck est le rendement de transformation par les éléments thermoélectriques de l'énergie thermique disponible entre les deux sources chaude et froide au contact de ces éléments et l'énergie électrique récupérée aux bornes des éléments thermoélectriques). Pour un couplage thermique de 98 %, on récupère ainsi au secondaire de cette alimentation entre les électrodes 10 et 14 une tension Us de 5 volts continus et un courant Is de 35 mA, soit une puissance totale de 0,18 watts.

Un tel résultat est obtenu, par exemple, avec une puce carrée d'environ 1 à 10 mm de côté et une épaisseur de matériau thermoélectrique d'environ 10 à 50 µm.

### Exemple 2

Dans un deuxième exemple de réalisation, on utilise les mêmes éléments et les mêmes valeurs de paramètres qu'à l'exemple 1 à l'exception des modifications suivantes : le substrat de silicium est dimensionné de telle manière que la résistance Rp soit égale à 2,3 kΩ, d'où il résulte un courant Ip de 100 mA et une puissance au primaire de 23 watts.

Au secondaire, on obtient pour une puissance totale de 1,3 watts, une tension de 5 volts et un courant de 270 mA.

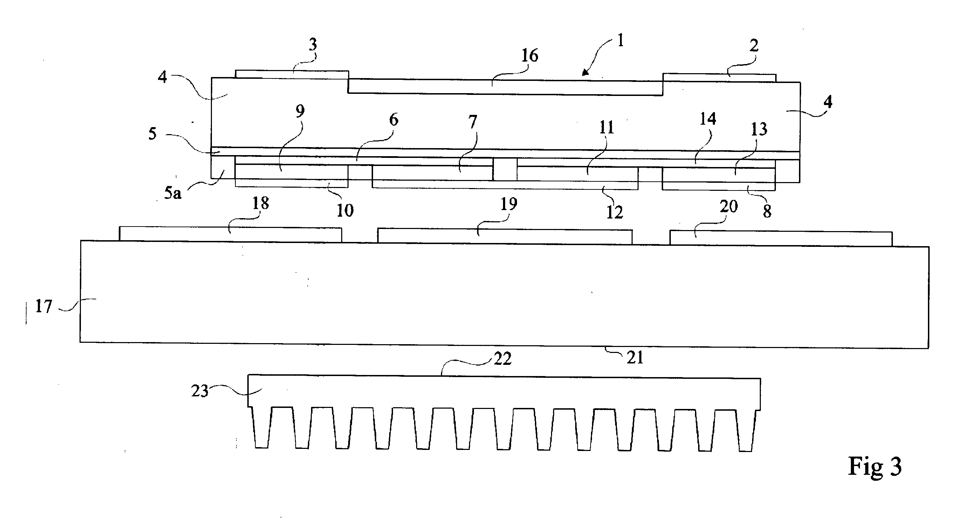

La figure 3 représente un exemple de montage de la structure de la figure 2. La structure est retournée de sorte que ses électrodes 14, 8 et 10 viennent respectivement au contact d'électrodes métalliques 18, 19 et 20 disposées à la surface d'un support 17 (l'électrode 19 étant optionnelle). Le substrat 10 est en un matériau à la fois isolant électrique et conducteur thermique, par exemple une céramique. Ce pourra aussi être un matériau électriquement conducteur (un métal) revêtu d'une couche mince électriquement isolante du côté de la structure 1. La face inférieure 21 du support 17 vient de préférence au contact de la face 22 d'un radiateur 23 qui permet de maintenir la température du support 17 aussi voisine que possible de la température souhaitée (source froide), par exemple la température ambiante. Si on n'utilise pas de radiateur, le support 17 pourra être une carte de circuit imprimé (PCB).

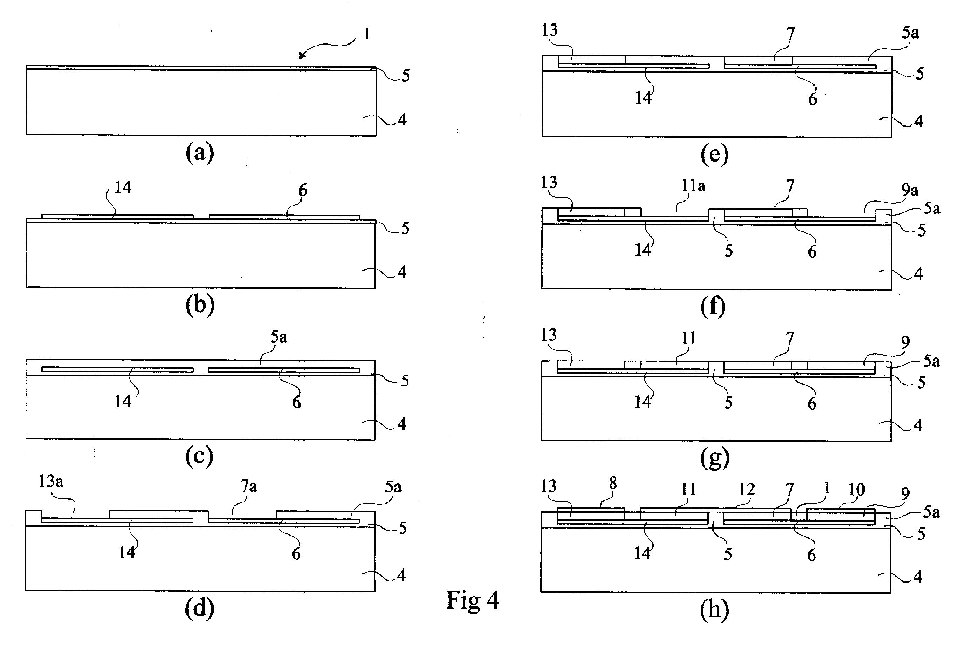

La figure 4 illustre des étapes successives d'un mode de réalisation possible du convertisseur monolithique isolé de la figure 2.

Sur des portions d'une plaquette de silicium 4, on dépose une couche uniforme 5 électriquement isolante et thermiquement conductrice (étape a) sur laquelle on dépose les deux électrodes 6 et 14 distantes l'une de l'autre (étape b), puis on recouvre l'ensemble d'une couche isolante 5a (étape c). On réalise ensuite deux ouvertures 7a et 13a dans la couche 5a au-dessus respectivement des électrodes 6 et 12 et mettant partiellement à jour celles-ci (étape d), puis on dépose les deux couches thermoélectriques 7 et 13 dopées par exemple P, respectivement dans les ouvertures 7a et 13a (étape e). On crée à nouveau deux ouvertures 9a, 11a dans la couche 5a au-dessus respectivement des électrodes 6 et 12, ouvertures respectivement à proximité des éléments thermoélectriques 7 et 13 (étape f). On dépose alors dans les ouvertures une couche de matériau thermoélectrique dopé N, respectivement 9 et 11 (étape g). Sur la face supérieure de l'élément 1, on a donc successivement dans un plan horizontal, un élément N, un élément P, un élément N puis un élément P qui sont séparés les uns des autres par la couche 5a qui les entoure également jusqu'aux extrémités de l'élément 1. Finalement, on recouvre la face supérieure des éléments thermoélectriques d'électrodes qui relient en série ces éléments : l'électrode d'extrémité 10 recouvre l'élément 9, l'électrode 8 relie électriquement les deux éléments 7 et 11 tandis que l'électrode 14 (sur laquelle on récupère la tension de sortie continue) recouvre l'autre extrémité de l'élément 13 (étape h).

Les différentes réalisations décrites ci-dessus sont susceptibles de diverses variantes et modifications qui apparaîtront à l'homme de métier.

Le substrat résistif 4 susceptible d'être chauffé par effet Joule est de préférence une plaquette de silicium mono-cristallin car les technologies de fabrication associées ont été largement développées dans le cadre de la fabrication de circuits intégrés et de composants MEMS. L'homme de l'art notera toutefois que d'autres substrats résistifs pourraient être utilisés.

Les éléments thermoélectriques pourront être en tellure de bismuth dopé (N ou P) de manière appropriée. On peut également utiliser d'autres matériaux semiconducteurs thermoélectriques tels que par exemple le tellure de plomb, le silicium-germanium, le bismuth-antimoine, etc. à condition que leur facteur de mérite soit suffisant dans les gammes de températures auxquelles on souhaite utiliser cette alimentation (par exemple pour des températures ambiantes de -40 à +80°C). En effet, le facteur de mérite de ces matériaux est proportionnel au coefficient Seebeck qui caractérise la conversion chaleur/courant de l'élément et plus le facteur de mérite est élevé, plus le coefficient Seebeck du matériau est élevé.

La couche isolante 5 initialement déposée sur le substrat 4 sera de préférence une couche mince d'oxyde de silicium lorsque le substrat est en silicium. On pourra aussi utiliser par exemple une couche de matériau de type céramique.

Le support 17 de l'élément 1 pourra être tout type de support pouvant être métallisé (électrode) et notamment les supports habituellement utilisés dans la technique de l'assemblage des circuits imprimés, tels que polyester, poly-imide, PET, etc. De préférence, on utilisera des supports de type céramique dont la conduction thermique est généralement plus élevée que celle des matières plastiques citées ci-dessus.

Il est également possible de connecter une pluralité d'éléments thermoélectriques entre eux dans la mesure où on utilise ces éléments par paires (un élément P et un élément N connectés en série). Ces paires peuvent être reliées entre elles en série, série parallèle ou parallèle ; elles peuvent être disposées en ligne comme cela a été décrit ou selon toute autre configuration géométrique souhaitée.

Le convertisseur électrique monolithique isolé décrit ici peut être léger et peu encombrant. Il pourra donc être incorporé dans un téléphone portable pour constituer le chargeur de la batterie de ce téléphone portable. L'appareil portable pourra alors être relié à une prise de courant à l'aide d'un simple câble électrique.

Selon un avantage de la présente invention, la source électrique primaire a pour seule fonction de créer un échauffement par effet Joule. Il pourra donc s'agir d'une tension continue ou alternative, de fréquence quelconque (50 ou 60 Hz).

Par ailleurs, on pourra prévoir du côté de la face inférieure plusieurs jeux d'électrodes pour optimiser le fonctionnement du convertisseur quand des tensions différentes, par exemple 110 et 220 V sont appliquées à son primaire.

## Revendications

1. Convertisseur électrique monolithique isolé comprenant, sur un substrat en un matériau (4) résistif dont la face inférieure comporte deux électrodes d'entrée (2, 3) distantes l'une de l'autre constituant un primaire :
une couche isolante (5), et
au moins deux éléments de matériaux thermoélectriques semiconducteurs (7, 9) dopés respectivement P et N connectés électriquement en série, les extrémités de la connexion série constituant le secondaire du convertisseur.

2. Convertisseur selon la revendication 1, dans lequel chaque élément thermoélectrique comprend une métallisation sur sa face supérieure et une métallisation sur sa face inférieure.

3. Convertisseur selon la revendication 1, dans lequel le substrat est en silicium.

4. Convertisseur selon la revendication 1, dans lequel le premier élément (7) de matériau thermoélectrique semiconducteur dopé P est constitué de tellure de bismuth dopé à l'antimoine et le second élément (9) de matériau thermoélectrique semiconducteur dopé N est constitué de tellure de bismuth dopé au sélénium.

5. Convertisseur selon la revendication 1, comportant une pluralité de cellules thermoélectriques connectées en série les unes aux autres.

6. Téléphone portable muni d'un convertisseur selon l'une quelconque des revendications précédentes.

## Claims

1. An isolated monolithic electric converter comprising, on a substrate made of a resistive material (4) with a lower surface having two input electrodes (2, 3) distant from each other forming a primary:
an insulating layer (5), and
at least two respectively P- and N-doped thermoelectric semiconductor elements (7, 9) electrically connected in series, the ends of the series connection forming the secondary of the converter.

2. The converter of claim 1, wherein each thermoelectric element comprises a metallization on its upper surface and a metallization on its lower surface.

3. The converter of claim 1, wherein the substrate is made of silicon.

4. The converter of claim 1, wherein the first P-doped thermoelectric semiconductor element (7) is formed of bismuth tellurium doped with antimony and the second N-doped thermoelectric semiconductor element (9) is formed of bismuth tellurium doped with selenium.

5. The converter of claim 1, comprising a plurality of thermoelectric cells series-connected to one another.

6. A cell phone provided with the converter of any of the foregoing claims.

## Patentansprüche

1. Isolierter monolithischer elektrischer Wandler mit folgenden Merkmalen auf einem Substrat, das Widerstand material (4) aufweist, dessen Unterseite zwei Eingangselektroden (2,3) trägt, die voneinander getrennt sind und eine Primärseite bilden:
eine Isolationsschicht (5) und
wenigstens zwei P- beziehungsweise N-dotierte thermoelektrische Halbleiterelemente (7, 9), die elektrisch in Reihe verbunden sind, wobei die Enden der Reihenverbindung die Sekundärseite des Wandlers bilden.

2. Wandler nach Anspruch 1, wobei jedes thermoelektrische Element eine Metallisierung auf seiner Oberseite und eine Metallisierung auf seiner Unterseite aufweiset.

3. Wandler nach Anspruch 1, wobei das Substrat aus Silicium ist.

4. Wandler nach Anspruch 1, wobei das erste P-dotierte thermoelektrische Halbleiterelement (7) aus mit Antimon dotiertem Bismuth-Tellurium gebildet ist und das zweite N-dotierte thermoelektrische Halbleiterelement (9) aus mit Selen dotiertem Bismuth-Tellurium hergestellt ist.

5. Wandler nach Anspruch 1, mit einer Vielzahl von thermoelektrischen Zellen, die zueinander in Reihe geschaltet sind.

6. Mobiltelefon, welches den Wandler nach einen der vorangehenden Ansprüche aufweist.
